# EUROPEAN PATENT SPECIFICATION

(11) **EP 1 368 672 B1**
(45) Date of publication and mention of the grant of the patent: **10.08.2005**
(21) Application number: 01986347.1
(22) Date of filing: 02.10.2001
(51) Int. Cl.: G01R 31/3185

(54) **A SCAN TEST SYSTEM AND METHOD FOR MANIPULATING LOGIC VALUES THAT REMAIN CONSTANT DURING NORMAL OPERATIONS**
SCAN-TEST- SYSTEM UND -METHODE ZUM MANIPULIEREN DER LOGIK-WERTE, DIE WÄHREND NORMALBETRIEB KONSTANT BLEIBEN
SYSTEME ET PROCEDE D'ESSAI DE BALAYAGE DESTINES A LA MANIPULATION DE VALEURS LOGIQUES RESTANT CONSTANTES PENDANT DES OPERATIONS NORMALES

(30) Priority: 02.10.2000 US 677939
(43) Date of publication of application: 10.12.2003
(73) Proprietor: Koninklijke Philips Electronics N.V., 5621 BA Eindhoven (NL)
(72) Inventor: SETHIA, Rajeev, NL-5656 AA Eindhoven (NL)
(74) Representative: Duijvestijn, Adrianus Johannes
(86) International application number: PCT/EP2001/011403
(87) International publication number: WO 2002/029422

(56) References cited:
- EP-A- 0 780 767
- MAUNDER C M: "IEEE STANDARD TEST ACCESS PORT AND BOUNDARY-SCAN ARCHITECTURE" , IEEE STANDARD TEST ACCESS PORT AND BOUNDARY SCAN ARCHITECTURE. APPROVED 15 FEB., 1990, IEEE STANDARDS, NEW YORK, IEEE, US, VOL. 1149.1-1990 XP002925379 page 10-1 -page 10-22

## Description

### FIELD OF THE INVENTION

The present invention relates to the field of electrical integrated circuit testing. More particularly, the present invention relates to a system and method that facilitates manipulation of logic values during scan operations, that remain constant during normal operations.

### BACKGROUND OF THE INVENTION

Electronic systems and circuits have made a significant contribution towards the advancement of modern society and are utilized in a number of applications to achieve advantageous results. Numerous electronic technologies such as digital computers, calculators, audio devices, video equipment, and telephone systems have facilitated increased productivity and reduced costs in analyzing and communicating data, ideas and trends in most areas of business, science, education and entertainment. Usually the components or devices of an electronic system are tested to ensure the electronic system operates properly in order for the desired results to be realized. Digital electronic system testing procedures usually involve the manipulation of logic values applied to the components or devices of the electronic system. Frequently, digital electronic systems include logic gates tied to a particular logic value during normal operations. Manipulation of the normally constant logic values usually provides greater testing flexibility but it is typically very difficult to manipulate constant logic values.

The complexity of commonly used integrated circuits (IC) included in system-on-chip (SOC) designs has advanced dramatically and built in self test (BIST) diagnostics capability is essential for effective circuit testing, debugging, and maintenance. Modem BIST techniques typically include the insertion of a scan test architecture in an IC. Scan testing of complex electronic systems and circuits often includes the application of test vectors to stimulate certain aspects of a circuit (e.g., a functional logic component) and observation of the resulting output from the circuit. Usually, scan test architectures include scan test chains comprising scan test components or devices (e.g., scan test cells) coupled together. The scan test elements communicate test vectors to components of an IC and interact with functional logic utilized to perform non-test or normal operations of the IC. Typically, scan test cells are designed to scan or shift scan test information (e.g., test vectors) via the scan test chain to appropriate locations in a circuit, capture scan test information and then shift the information out via scan test cells.

Usually it is desirable to have significant scan test coverage, the greater the test coverage the greater the capacity of a scan test system and method to detect faults. Boundary scan testing is a very common method of scan testing included in typical BIST schemes. International Electrical and Electronic Engineering (IEEE) Standard 1149.1 (also referred to as Joint Task Action Group (JTAG)) boundary scan compliant architecture is one of the most prevalent boundary scan test schemes. It is also very important to have internal scan test capabilities to provide greater scan test coverage.

Typically, scan test participation by logic gates tied to a particular logic value is relatively limited. A traditional logic gate input tied to a particular logic value does not usually permit desired testing activities in which the tied input is manipulated by testing procedures. It can also block the scan testing of other logic components connected to it.

### SUMMARY OF THE INVENTION

What is required is a system and method that facilitates scan test manipulation of logic values tied to the input of logic gates and ensure the logic value the gate input is tied to remains constant during normal operations. Scan testing of integrated circuit components with an ATPG tool should be supported and the system and method should accommodate utilization of existing scan testing architectures.

The present invention is a system and method that facilitates scan test manipulation of logic values input to combinational logic (e.g., a logic gate) and ensures that the logic value of the combinational logic input is tied to remain constant during normal operations. In one embodiment of the present invention, scan testing of integrated circuit components with an ATPG tool is supported and the system and method accommodates utilization of existing scan testing architectures. In one embodiment the present invention is a constant logic value manipulation scan test chain that includes a combinational circuit, a constant logic value scan test manipulation circuit, and a scan test element. The combinational circuit performs functional operations during normal mode. The constant logic value scan test manipulation circuit provides a logic value output that remains constant during normal operations and changes in accordance with scan test input information during scan test operations. The scan test element communicates test vectors to functional components and interacts with functional logic utilized to perform normal operations. In one exemplary implementation of the present invention the combinational circuit is a logic gate and the logic value output by the constant logic value scan test manipulation circuit is coupled to an input of the logic gate. The logic value input to the logic gate remains constant during normal operations and is manipulated in accordance with scan test input information during scan test operations.

### BRIEF DESCRIPTION OF THE DRAWINGS

Fig. 1 is a block diagram a traditional IC that includes logic gates tied to a particular logical input value.
Fig. 2 is a block diagram illustration of a constant logic value manipulation scan test chain, one embodiment of the present invention.
Fig. 3 is a block diagram of a constant logic value scan test manipulation circuit, one embodiment of the present invention.
Fig. 4 is a block diagram of a logic value production circuit include in one embodiment of a present invention logic value production circuit.
Fig. 5 is a block diagram illustrating one embodiment of a present invention scan test controllable tied gate input system.
Fig. 6 is a block diagram illustrating an embodiment of a present invention scan test controllable tied gate input system that provides granular control of logic values.

### DETAILED DESCRIPTION OF THE INVENTION

Reference will now be made in detail to the preferred embodiments of the invention, a scan test system and method for manipulating logic values that remain constant during normal operations, examples of which are illustrated in the accompanying drawings. While the invention will be described in conjunction with the preferred embodiments, it will be understood that they are not intended to limit the invention to these embodiments. On the contrary, the invention is intended to cover alternatives, modifications and equivalents, which may be included within the scope of the invention as defined by the appended claims. Furthermore, in the following detailed description of the present invention, numerous specific details are set forth in order to provide a thorough understanding of the present invention. However, it will be obvious to one ordinarily skilled in the art that the present invention may be practiced without these specific details. In other instances, well known methods, procedures, components, and circuits have not been described in detail as not to unnecessarily obscure aspects of the current invention.

One embodiment of the present invention includes a constant logic value scan test manipulation system and method. In one embodiment of the present invention, a constant logic value scan test manipulation system and method is compatible with normal scan testing methodologies. During testing operations the constant logic value scan test manipulation system and method permits manipulation of a logic value output tied to combinational logic inputs. During normal operations the constant logic value scan test manipulation system and method provides a constant logic value output. In one exemplary implementation of the present invention, the constant logic value scan test manipulation system and method is configured in a manner that is compatible with a scan test architecture familiar to the ATPG tool and easily accessible by the ATPG tool.

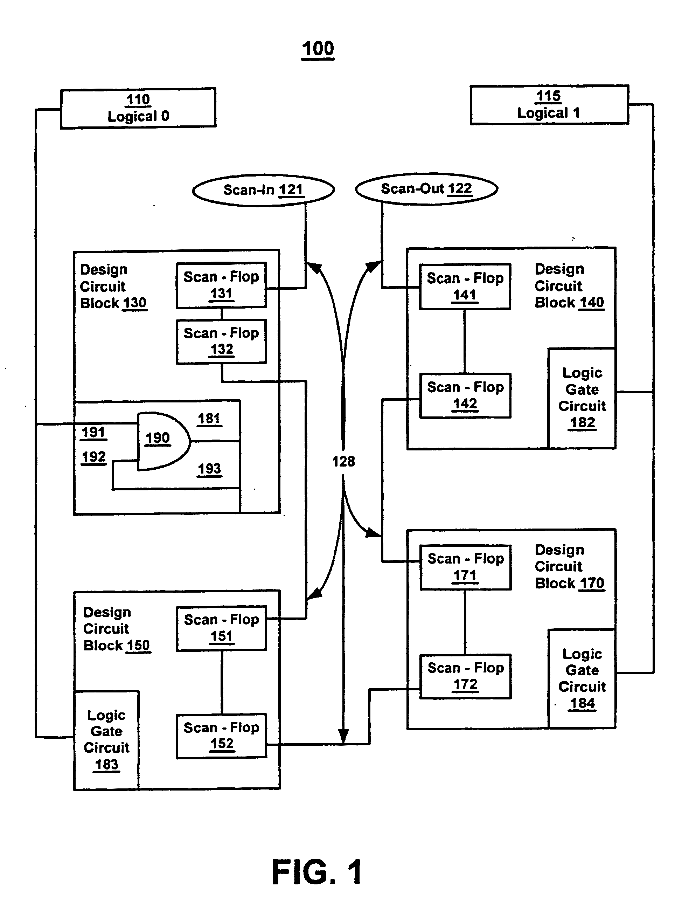

Fig. 1 is a block diagram of a traditional IC 100, one example of a traditional IC that includes logic gates tied to a particular logical input value. Design circuit blocks 130, 140, 140, 170 include a logic gate circuit 181 through 184 respectively, each of which comprise one or more logic circuit gates. For example, design circuit block 130 includes AND gate 190. Gate input 192 and gate output 193 are coupled to other gates (not shown) in design circuit block 130. Gate input 191 is tied to logical 0 value source 110. Scan test input port 121 and scan test output port 122 are connected via scan test chain 128 to scan test flip flops 131, 132; 141, 142; 151, 152; 171, 172 included in design circuit block 130, 140, 150, 170 respectively. Gate inputs of logic gates included in logic gate circuit 181 through 184 are tied to logical 0 value source 110 or logical 1 value source 115 and are not manipulated during scan test operations by scan test vectors.

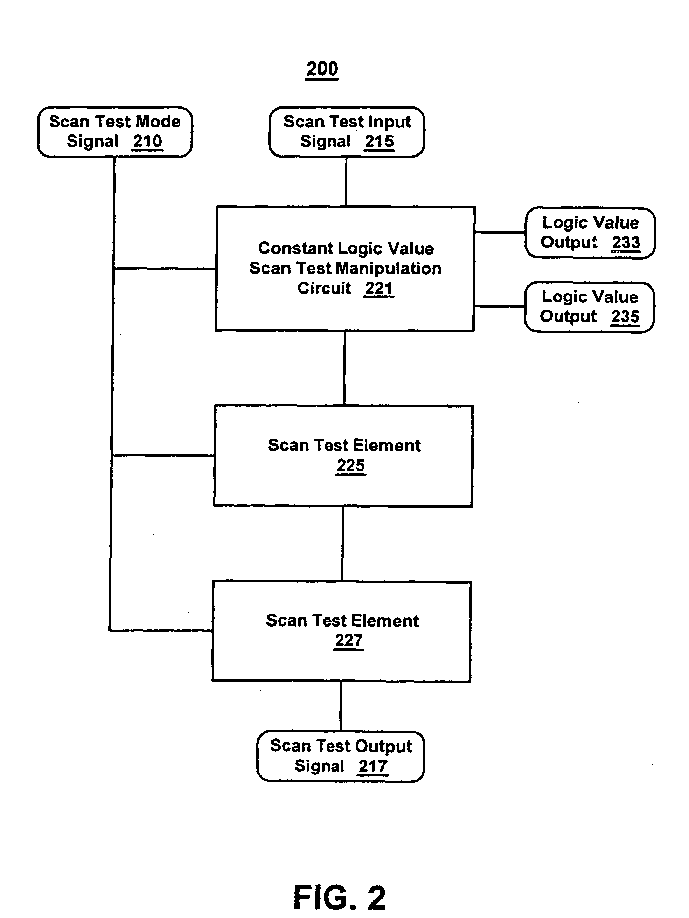

Fig. 2 is a block diagram illustration of constant logic value manipulation scan test chain 200, one embodiment of the present invention. Constant logic value manipulation scan test chain 200 comprises constant logic value scan test manipulation circuit 221, scan test element 225 and scan test element 227. Constant logic value scan test manipulation circuit 221 is coupled to scan test element 225 which is coupled to scan test element 227. Constant logic value scan test manipulation circuit 221 provides a logic value output e.g., logic value output 233 or logic value output 235 that remains constant during normal operations and changes in accordance with scan test input information (e.g., a scan test vector) during scan test operations. Scan test elements 225 and 227 communicate test vectors e.g., scan test input signal 215 to functional components of an IC (not shown) and interact with functional logic utilized to perform non-test or normal operations of the IC. For example, scan test elements 225 and 227 include scan test cells that scan or shift scan test information (e.g., test vectors) via the scan test chain to a normal function circuit, capture scan test information and then shift the information out e.g., scan test output signal 217.

In one embodiment of the present invention, scan test mode signal 210 directs the components of constant logic value manipulation scan test chain 200 to operate in normal function mode or scan test mode. When scan test mode signal 210 directs the components of constant logic value manipulation scan test chain 200 to operate in normal operation mode, constant logic value scan test manipulation circuit 221 maintains a logic value output e.g., logic value output 233 or logic value output 235 at a constant logic value. When scan test mode signal 210 directs the components of constant logic value manipulation scan test chain 200 to operate in scan test mode, constant logic value scan test manipulation circuit 221 manipulates the logic value output in accordance with scan test input signal 215.

In one exemplary implementation of the present invention, constant logic value scan test manipulation circuit 221 maintains or manipulates logic value output 233 and logic value output 235. When scan test input signal 215 is a logical 0 constant logic value scan test manipulation circuit 221 manipulates logic value output 233 to be a logic 0 value and logic value output 235 to be a logic 1 value. When scan test input signal 215 is a logical 1 value constant logic value scan test manipulation circuit 221 manipulates logic value output 233 to be a logic 1 value and logic value output 235 to be a logic 0 value. When operating in normal function mode, constant logic value scan test manipulation circuit 221 provides constant logic values on logic value output 233 and logic value output 235 that do not change, regardless of the value of scan test input signal 215. Logic value output 233 and logic value output 235 are coupled to the inputs of normal function combinational logic circuits (e.g., logic gate circuits not shown).

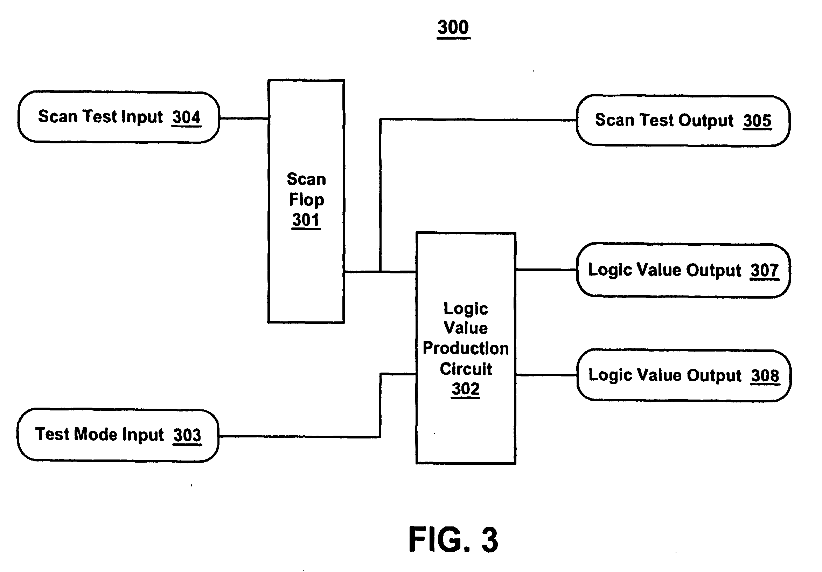

Fig. 3 is a block diagram of constant logic value scan test manipulation circuit 300, one embodiment of the present invention. Constant logic value scan test manipulation circuit 300 comprises scan flop 301, logic value production circuit 302, scan test mode input 303, scan test input 304, scan test output 305, logic value output 307 and logic value output 308. Scan flop 301 is coupled to scan test input 304, scan test output 305, and logic value production circuit 302 which is coupled to scan test mode input 303, logic value output 307 and logic value output 308. Scan-flop 301 stores a scan test input logic value communicated by scan test input 304. Scan test output 305 communicates a scan test output signal from scan flop 301. Logic value production circuit 302 ensures logic values communicated on logic value output 307 and 308 remain constant during normal operation mode and provides manipulation of the logic value during scan test operation mode based upon the scan test input logic value stored in scan flop 301. Scan test mode input 303 communicates a scan test mode signal that directs logic value production circuit 302 when to operate in scan test operation mode and when to operate in normal operation mode. Logic value output 307 and 308 communicate logic values which are coupled (e.g., tied) to other devices (not shown).

Scan test mode signal 303 operates as a controlling signal for constant logic value scan test manipulation circuit 300. Scan test mode signal 303 is asserted (e.g., logic 1) during scan test operations. When scan test mode signal 303 is asserted the first logic value output and the second logic value are controlled by the logic value stored in scan flop 301. When scan test mode signal 303 is de-asserted the logic value stored in scan-flop 301 does not impact the first logic value output and the second logic value output. In one exemplary implementation of the present invention, the first logic value output is a constant logical 0 value and the second logic value output is a constant logical 1 value during normal operations, irrespective of the logical value stored in scan-flop 301. During scan test operations, the first logic value output is a logical 0 value and the second logic value is a logical 1 if the logical value stored in scan-flop 301 is a logical 0 value. The first logic value output is a logical 1 value and the second logic value is a logical 0 value if the logical value stored in scan-flop 301 is a logical 1 when test mode signal 303 is asserted (e.g., during scan test operations).

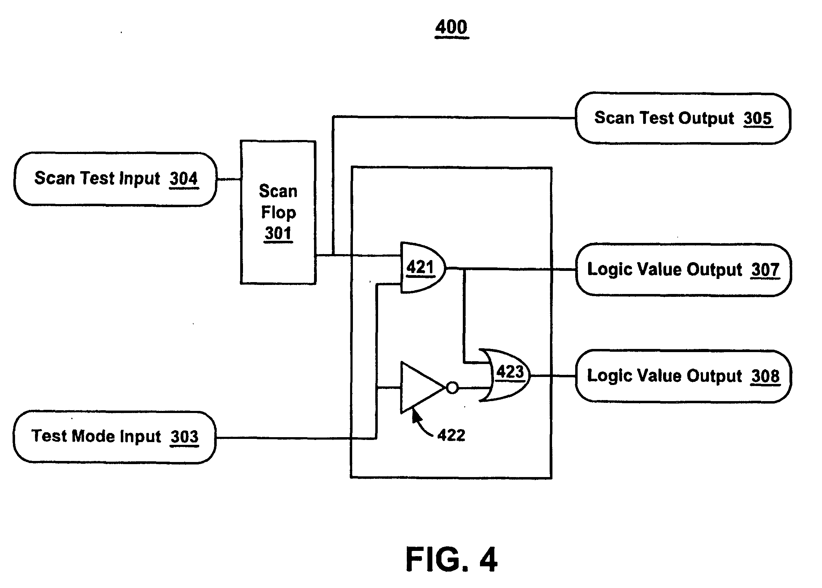

Fig. 4 is a block diagram of logic value production circuit 400, one embodiment of logic value production circuit 302. Logic value production circuit 400 comprises AND gate 421, NOT gate 422, and OR gate 423. Scan-flop 301 is coupled to AND gate 421 which is coupled to NOT gate 422 and OR gate 323. AND gate 421 provides a constant first logic value (e.g., logic 0) on logic value output 307 when scan test mode signal 303 is not asserted (e.g., logical 0 value), irrespective of the logical value stored in scan-flop 301. AND gate 421 changes the logical value on logic value output 307 in accordance with the output of scan flop 301 during scan test operations (e.g., when scan test mode signal 303 is asserted). OR gate 423 provides a constant second logic value (e.g., logic 1) on logic value output 308 when scan test mode signal 303 is not asserted, irrespective of the logical value stored in scan-flop 301. OR gate 423 changes the logical value on logic value output 307 in accordance with the output of scan flop 301 during scan test operations. NOT gate 422 assures that the second logic value is the opposite of the first logic value.

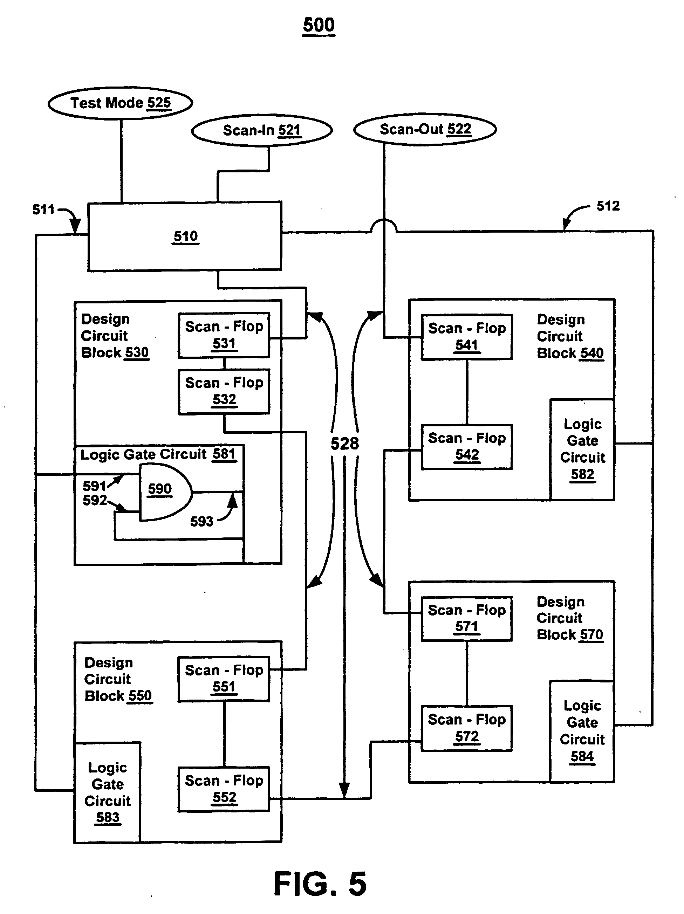

Fig. 5 is a block diagram of a scan test controllable tied gate input system 500, one embodiment of the present invention. Traditional IC 500 comprises design circuit block 530, design circuit block 540, design circuit block 550 and design circuit block 570, and constant logic value scan test manipulation circuit 510. Constant logic value scan test manipulation circuit 510 is coupled to design circuit block 530, design circuit block 540, design circuit block 550 and design circuit block 570. Design circuit blocks 530 through 570 include a logic gate circuit 581 through 584 respectively which comprise one or more logic circuit gates. For example, logic gate circuit 581 includes AND gate 590. Gate input 592 and gate output 593 are coupled to other gates (not shown) in design circuit block 530. Gate input 591 is tied to constant logic value scan test manipulation circuit 510.

In one exemplary implementation of the present invention, each of the design circuit blocks 530 through 570 comprise scan test elements such as scan test flip flops that are included in scan test chain 528. For example design circuit block 530 includes scan flip flop 531 and scan flip flop 532, design circuit block 540 includes scan flip flop 541 and scan flip flop 542, design circuit block 550 includes scan flip flop 551 and scan flip flop 552, and design circuit block 570 includes scan flip flop 571 and scan flip flop 572. The scan test flip flops are coupled to other components (not shown) of the design circuit blocks and perform scan test capture and shifting during scan test operations and register functions during normal operations. Gate inputs of logic gates included in logic gate circuit 581 through 584 tied to constant logic value scan test manipulation circuit 510 are held constant during normal operations and manipulated during test operations by test scan vectors in accordance with scan test input signal 521 under control of scan test output test mode signal 525. The values of these gates can be retrieved from scan test output signal 522.

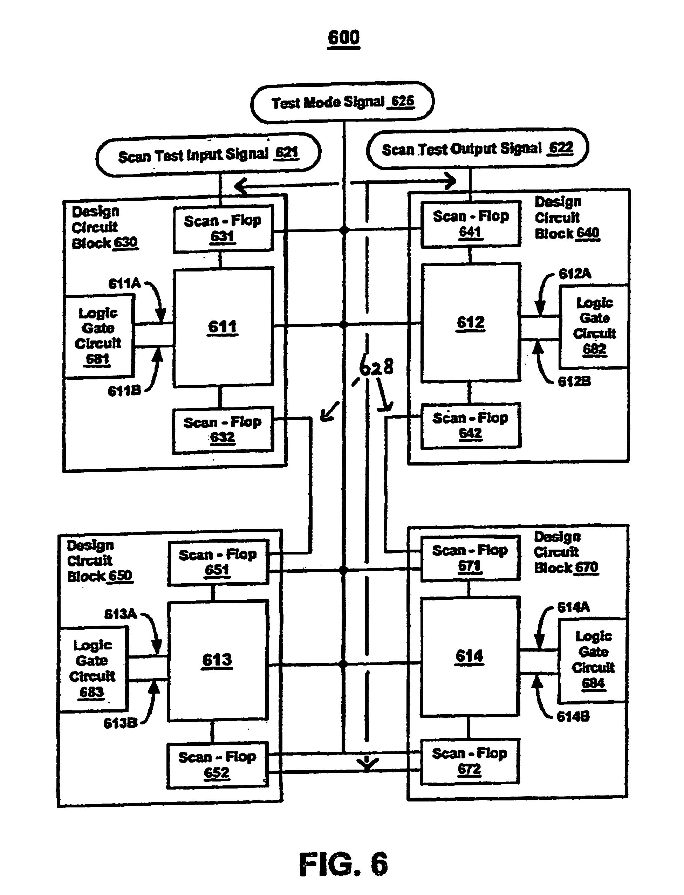

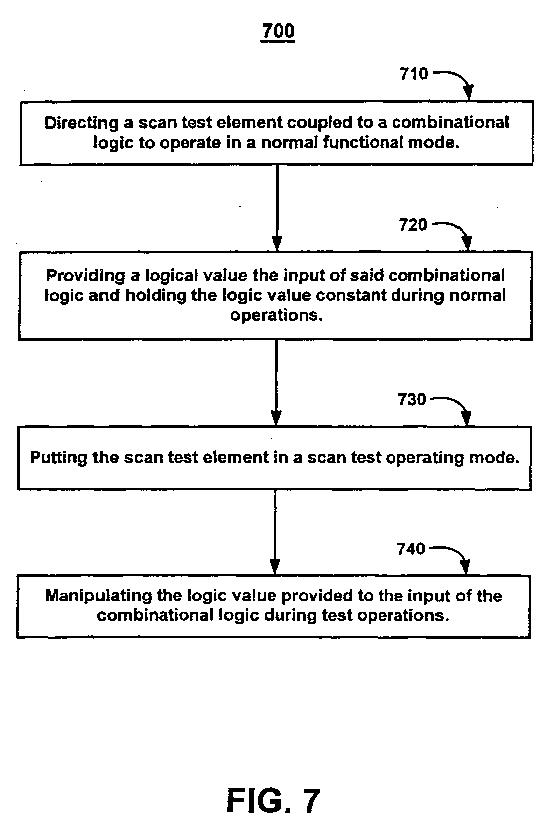

Fig. 6 is a block diagram of a scan test controllable tied gate input system 600, one embodiment of the present invention. Scan test controllable tied gate input system 600 is similar to scan test controllable tied gate input system 500, except scan test controllable tied gate input system 600 provides greater granularity in the manipulation of tied logic values. Scan test controllable tied gate input system 600 comprises design circuit block 630, design circuit block 640, design circuit block 650 and design circuit block 670. Similar to scan test controllable tied gate input system 500, design circuit blocks 630 through 670 include a logic gate circuit 681 through 684 respectively which comprise one or more logic circuit gates. In addition, design circuit blocks 630 through 670 include constant logic value scan test manipulation circuit 611 through 614 respectively.

Similar to scan test controllable tied gate input system 500, the design circuit blocks 630 through 670 include scan test elements such as scan test flip flops (e.g., scan flip flop 631, 632, 651, 652, 641, 642, 671, and 672) that are included in scan test chain 628. The scan test flip flops are coupled to other components (not shown) of the design circuit blocks and perform scan test capture and shifting during scan test operations and register functions during normal operations. Scan test manipulation circuit 611 through 614 are included in scan test chain 628. For example, scan test manipulation circuit 611 is coupled to scan flip flop 631 and 632, scan test manipulation circuit 613 is coupled to scan flip flop 651 and 652, scan test manipulation circuit 612 is coupled to scan flip flop 641 and 642, and scan test manipulation circuit 614 is coupled to scan flip flop 671 and 672. Scan test input signal 621 is coupled to design circuit block 630 through 670 via scan test chain 628.

Scan test manipulation circuit 611 through 614 provide greater granularity in the manipulation of tied logic values. Scan test manipulation circuit 611 through 614 are coupled to gate inputs of logic gates included in design circuit block 630, 640, 650 and 670. For example, scan test manipulation circuit 611 is coupled to logic gate circuit 681, scan test manipulation circuit 613 is coupled to logic gate circuit 683, scan test manipulation circuit 614 is coupled to logic gate circuit 684, and scan test manipulation circuit 612 is coupled to logic gate circuit 682. Scan test manipulation circuit 611 through 614 supply constant logic values to logic gate circuit 681 through 684 respectively during normal operations. Scan test manipulation circuit 611 through 614 manipulate the logic values they supply to logic gate circuit 681 through 684 individually during scan test operations. This takes place under control of scan test mode signal 625. Like in gate input system 500, the logic values are manipulated in accordance with scan test input signal 621 and outputted via scan test output signal 622.

A constant logic value scan test manipulation method can be described as follows, according to one embodiment of the present invention. Constant logic value scan test manipulation method is compatible with normal scan testing methodologies. During testing operations, constant logic value scan test manipulation method permits manipulation of a logic value output tied to combinational logic inputs. During normal operations constant logic value scan test manipulation method provides a constant logic value output.

In a first step, a scan test element coupled to a combinational logic is directed to operate in a normal function mode. In one embodiment of the present invention a scan test mode signal is utilized to direct the scan test element to operate in a normal function mode. In one exemplary implementation of constant logic value scan test manipulation method, the scan test element is a constant logic value scan test manipulation circuit (e.g., constant logic value scan test manipulation circuit 221)

In a second step, a logical value is provided to the input of combinational logic and held constant during normal operations. In one embodiment of present invention, the logic value is supplied to the input of a logic gate.

The scan test element coupled to the combinational logic is put in a scan test operating mode in a third step. In one embodiment of the present invention, the scan test element is put in scan test mode in accordance with a test mode instruction signal.

In a fourth step, the logical value provided to the input of the combinational logic is manipulated during test operations. In one embodiment of the present invention, the logical value provided to the input of the combinational logic (e.g., a gate) is manipulated in accordance with a scan test input signal. In one exemplary implementation of the present invention, the manipulation of the logic value input of the gate is utilized to facilitate control of an input of a logic gate tied to the logic value during test operations.

Thus, the present invention is a system and method that facilitates scan test manipulation of logic values input to combinational logic (e.g., a logic gate) and ensures the logic value of the combinational logic input is tied to remain constant during normal operations. In one embodiment of the present invention, scan testing of integrated circuit components with an ATPG tool is supported and the system and method accommodates utilization of existing scan testing architectures.

The foregoing descriptions of specific embodiments of the present invention have been presented for purposes of illustration and description. The embodiments were chosen and described in order to best explain the principles of the invention and its practical application, to thereby enable others skilled in the art to best utilize the invention and various embodiments with various modifications as are suited to the particular use contemplated. It is intended that the scope of the invention be defined by the Claims appended hereto and their equivalents.

## Claims

1. A constant logic value scan test manipulation circuit comprising:
a scan-flop (301) adapted to store a scan test input logic value;
a scan test input (304) coupled to said scan flop, said scan test input adapted to communicate a scan test input signal;
a scan test output (305) coupled to said scan flop, said scan test output adapted to communicate a scan test output signal;
a logic value production circuit (302) coupled to said scan flop, said logic value production circuit adapted to ensure that a logic value remains constant during normal operation mode and to provide manipulation of said logic value during a scan test operation mode based upon said scan test input logic value stored in said scan flop;
a scan test mode input (303) coupled to said logic value production circuit, said scan test mode input adapted to communicate a scan test mode signal that directs said logic value production circuit when to operate in scan test mode and when to operate in normal operation mode; and
a logic value output (307) coupled to said logic value production circuit, said logic output adapted to communicate said logic value.

2. The constant logic value scan test manipulation circuit of Claim 1, comprising a plurality of logic value outputs (307 and 308) coupled to said logic value production circuit.

3. The constant logic value scan test manipulation circuit of Claim 2 wherein said logic value production circuit comprises:
an AND gate (421) adapted to provide a constant first logic value on a first logic value output when not operating in a scan test mode irrespective of the logical value stored in said scan-flop and changes the logical value on said first value output in accordance with the output of said scan flop during scan test operations;
an OR gate (423) coupled to said AND gate, said OR gate adapted to provide a constant second logic value on a second logic value output when operating in scan test mode irrespective of the logical value stored in said scan-flop and changes said second logical value on said second logic value output in accordance with the output of said scan flop during scan test operations; and
a NOT gate (422) adapted to assure said second logic value is the opposite of said first logic value.

4. The constant logic value scan test manipulation circuit of Claim 1 wherein said logic value production circuit operates in scan test mode when said scan test mode signal (525) is asserted.

5. The constant logic value scan test manipulation circuit of Claim 1 wherein said logic value output is coupled to the input of a normal operation combinational circuit (530).

6. The constant logic value scan test manipulation circuit of Claim 1 wherein said logic value output is coupled to the input of a logic gate (581).

7. The constant logic value scan test manipulation circuit of Claim 1, wherein the constant logic value scan test manipulation circuit forms a part of a scan chain (628).

8. A constant logic value scan test manipulation method comprising the steps of:
directing a scan test element (510) coupled to combinational logic (530) to operate in a normal function mode;
providing a logical value (511) to the input of said combinational logic;
holding said logic value constant during normal operations;
putting said scan test element coupled to said combinational logic in a scan test operating mode; and
manipulating said logical value provided to the input of said combinational logic during test operations.

9. A constant logic value scan test manipulation method of Claim 8 further comprising the step of utilizing a scan test mode signal (525) to direct said scan test element to operate in a normal function mode or a scan test mode.

10. A constant logic value scan test manipulation method of Claim 8 wherein said scan test element is a constant logic value scan test manipulation circuit (510).

11. A constant logic value scan test manipulation method of Claim 8 wherein said logic value is supplied to the input of a logic gate (581).

12. A constant logic value scan test manipulation method of Claim 8 wherein said logical value provided to said input of said combinational logic is manipulated in accordance with a scan test input signal (521).

13. A constant logic value scan test manipulation method of Claim 8 further comprising the step of utilizing said logic value input to facilitate control of an input of a logic gate (581) during test operations.

## Patentansprüche

1. Manipulationsschaltung mit einem konstanten Logikwert, welche die nachfolgenden Elemente aufweist:
- eine Abtast-Flip-Flop-Schaltung (301), dazu vorgesehen, einen Abtasttesteingangslogikwert zu speichern;
- einen Abtasttesteingang (304), der mit der genannten Abtast-Flip-Flop-Schaltung gekoppelt ist, wobei der genannte Abtasttesteingang dazu vorgesehen ist, ein Abtasttesteingangssignal zu kommunizieren;
- einen Abtasttestausgang (305), der mit der genannten Abtast-Flip-Flop-Schaltung gekoppelt ist, wobei der genannte Abtasttestausgang dazu vorgesehen ist, ein Abtasttestausgangssignal zu kommunizieren;
- eine Logikwerterzeugungsschaltung (302), die mit der genannten Abtast-Flip-Flop-Schaltung gekoppelt ist, wobei die genannte Logikwerterzeugungsschaltung dazu vorgesehen ist, zu gewährleisten, dass in der Normalbetriebsmode ein logischer Wert konstant bleibt, und Manipulation des genannten Logikwertes während einer Abtasttestbetriebsmode zu schaffen, und zwar auf Basis des genannten Abtasttesteingangslogikwertes, der in der genannten Abtast-Flip-Flop-Schaltung gespeichert ist;
- einen Abtasttestmodeeingang (303), der mit der genannten Logikwerterzeugungsschaltung gekoppelt ist, wobei der genannte Abtasttestmodeeingang dazu vorgesehen ist, ein Abtasttestmodesignal zu kommunizieren, das die genannte Logikwerterzeugungsschaltung steuert, wenn diese in der Abtasttestmode arbeitet und wenn sie in der normalen Betriebsart arbeitet; und
- einen Logikwertausgang (307), der mit der genannten Logikwerterzeugungsschaltung gekoppelt ist, wobei der genannte Logikausgang dazu vorgesehen ist, den genannten Logikwert zu kommunizieren.

2. Manipulationsschaltung nach Anspruch 1, mit einer Anzahl Logikwertausgänge (307 und 308), die mit der genannten Logikwerterzeugungsschaltung gekoppelt sind.

3. Manipulationsschaltung nach Anspruch 2, wobei die genannte Logikwerterzeugungsschaltung die nachfolgenden Elemente umfasst:
- ein UND-Gatter (421), das dazu vorgesehen ist, einen konstanten ersten Logikwert zu an einem ersten Logikwertausgang schaffen, wenn nicht in einer Abtasttestmode gearbeitet wird, ungeachtet des in der genannten Abtast-Flip-Flop-Schaltung gespeicherten Logikwertes und den logischen Wert an dem genannten ersten Wertausgang ändert, und zwar entsprechend dem Ausgang der genannten Abtastung im Abtasttestbetrieb;
- ein ODER-Gatter (423), das mit dem genannten UND-Gatter gekoppelt ist, wobei das genannte ODER-Gatter dazu vorgesehen ist, an einem zweiten Logikwertausgang einen konstanten zweiten Logikwert zu schaffen, wenn in der Abtasttestmode gearbeitet wird, ungeachtet des logischen Wertes, der in der genannten Abtast-Flip-Flop-Schaltung gespeichert ist und den genannten zweiten logischen Wert an dem genannten zweiten Logikwertausgang ändert entsprechend dem Ausgang der genannten Abtast-Flip-Flop-Schaltung während des Abtasttestbetriebs; und
- ein NOR-Gatter (422), dass dazu vorgesehen ist, zu gewährleisten, dass der genannte zweite logische Wert der Gegensatz des genannten ersten logischen Wertes ist.

4. Manipulationsschaltung nach Anspruch 1, wobei die genannte Logikwerterzeugungsschaltung in der Abtasttestmode arbeitet, wenn das genannte Abtasttestmodesignal (525) bestätigt wird.

5. Manipulationsschaltung nach Anspruch 1, wobei der genannte Logikwertausgang mit dem Eingang einer Normalbetrieb-Kombinationsschaltung (530) gekoppelt ist.

6. Manipulationsschaltung nach Anspruch 1, wobei der genannte Logikwertausgang mit dem Eingang eines logischen Gatters (581) gekoppelt ist.

7. Manipulationsschaltung nach Anspruch 1, wobei diese Schaltungsanordnung einen Teil einer Abtastkette (628) bildet.

8. Manipulationsverfahren, das die nachfolgenden Verfahrensschritte umfasst:
- das Steuern eines Abtasttestelementes (510), das mit der Kombinationslogik (530) gekoppelt ist um in der normalen Betriebsart zu funktionieren;
- das Liefern eines Logikwertes (511) zu dem Eingang der genannten Kombinationslogik;
- das Konstanthalten des genannten logischen Wertes im Normalbetrieb;
- das gekoppelt Halten des genannten Abtasttestelementes mit der genannten Kombinationslogik in einer Abtasttestbetriebsart; und
- das Manipulieren des genannten logischen Wertes, der dem Eingang der genannten Kombinationslogik im Testverfahren geliefert wird.

9. Manipulationsverfahren nach Anspruch 8, weiterhin mit dem Schritt der Benutzung eines Abtasttestmodesignals (525) zum Steuern des genannten Abtasttestelementes zum Funktionieren im Normalbetrieb oder im Abtasttestbetrieb.

10. Manipulationsverfahren nach Anspruch 8, wobei das genannte Abtasttestelement eine Manipulationsschaltung (510) ist.

11. Manipulationsverfahren nach Anspruch 8, wobei der genannten Logikwert dem Eingang eines logischen Gatters (581) zugeführt wird.

12. Manipulationsverfahren nach Anspruch 8, wobei der genannte Logikwert, der dem genannten Eingang der genannten Kombinationslogik zugeführt wird, entsprechend einem Abtasttesteingangssignal (521) manipuliert wird.

13. Manipulationsverfahren nach Anspruch 8, weiterhin mit dem Schritt der Benutzung des genannten Logikwerteingangs zum Ermöglichen einer Steuerung des Eingangs des logischen Gatters (581) im Testbetrieb.

## Revendications

1. Circuit de manipulation de test série de valeur logique constante comprenant :
une bascule (301) apte à stocker une valeur logique d'entrée de test série;
une entrée de test série (304) connectée à ladite bascule, ladite entrée de test série étant apte à communiquer un signal d'entrée de test série;
une sortie de test série (305) connectée à ladite bascule, ladite sortie de test série étant apte à communiquer un signal de sortie de test série;
un circuit de production de valeurs logiques (302) connecté à ladite bascule, ledit circuit de production de valeurs logiques étant apte à s'assurer qu'une valeur logique demeure constante dans le mode de fonctionnement normal et à assurer une manipulation de ladite valeur logique au cours d'un mode de fonctionnement de test série, sur la base de ladite valeur logique d'entrée de test série stockée dans ladite bascule;
une entrée de mode de test série (303) connectée audit circuit de production de valeurs logiques, ladite entrée de mode de test série étant apte à transmettre un signal de mode de test série qui amène ledit circuit de production de valeurs logiques au moment où il faut fonctionner en mode de fonctionnement de test série et au moment où il faut fonctionner en mode de fonctionnement normal, et
une sortie de valeur logique (307) connectée audit circuit de production de valeurs logiques, ladite sortie logique étant apte à transmettre ladite valeur logique.

2. Circuit de manipulation de test série de valeur logique constante suivant la revendication 1, comprenant une pluralité de sorties de valeur logique (307 et 308) connectées audit circuit de production de valeurs logiques.

3. Circuit de manipulation de test série de valeur logique constante suivant la revendication 2, dans lequel ledit circuit de production de valeurs logiques comprend :
une porte ET (421) apte à fournir une première valeur logique constante au niveau d'une première sortie de valeur logique lorsqu'elle ne fonctionne pas dans un mode de test série, indépendamment de la valeur logique stockée dans ladite bascule, et à modifier la valeur logique au niveau de ladite première sortie de valeur en fonction de la sortie de ladite bascule au cours d'opérations de test série;
une porte OU (423) connectée à ladite porte ET, ladite porte OU étant apte à fournir une seconde valeur logique constante au niveau d'une seconde sortie de valeur logique lorsqu'elle fonctionne dans un mode de test série, indépendamment de la valeur logique stockée dans ladite bascule, et à modifier ladite seconde valeur logique au niveau de ladite seconde sortie de valeur logique en fonction de la sortie de ladite bascule au cours d'opérations de test série, et
une porte OU (422) apte à assurer que ladite seconde valeur logique soit l'opposé de ladite première valeur logique.

4. Circuit de manipulation de test série de valeur logique constante suivant la revendication 1, dans lequel ledit circuit de production de valeurs logiques fonctionne dans un mode de test série lorsque ledit signal de test série (525) est activé.

5. Circuit de manipulation de test série de valeur logique constante suivant la revendication 1, dans lequel ladite sortie de valeur logique est connectée à l'entrée d'un circuit combinatoire de fonctionnement normal (530).

6. Circuit de manipulation de test série de valeur logique constante suivant la revendication 1, dans lequel ladite sortie de valeur logique est connectée à l'entrée d'une porte logique (581).

7. Circuit de manipulation de test série de valeur logique constante suivant la revendication 1, dans lequel le circuit de manipulation de test série de valeur logique constante forme une partie d'une chaîne de balayage (628).

8. Procédé de manipulation de test série de valeur logique constante comprenant les étapes pour :
amener un élément de test série (510) connecté à la logique combinatoire (530) à fonctionner dans un mode de fonctionnement normal;
fournir une valeur logique (511) à l'entrée de ladite logique combinatoire;
maintenir ladite valeur logique constante au cours d'opérations normales;
placer ledit élément de test série connecté à ladite logique combinatoire dans un mode de fonctionnement de test série, et
manipuler ladite valeur logique fournie à l'entrée de ladite logique combinatoire au cours d'opérations de test.

9. Procédé de manipulation de test série de valeur logique constante suivant la revendication 8, comprenant l'étape d'utilisation d'un signal de mode de test série (525) afin d'amener ledit élément de test série à fonctionner dans un mode de fonctionnement normal ou dans un mode de test série.

10. Procédé de manipulation de test série de valeur logique constante suivant la revendication 8, dans lequel ledit élément de test série est un circuit de manipulation de test série de valeur logique constante (510).

11. Circuit de manipulation de test série de valeur logique constante suivant la revendication 8, dans lequel ladite valeur logique est fournie à l'entrée d'une porte logique (581).

12. Procédé de manipulation de test série de valeur logique constante suivant la revendication 8, dans lequel ladite valeur logique fournie à ladite entrée de ladite logique combinatoire est manipulée en fonction d'un signal d'entrée de test série (521).

13. Procédé de manipulation de test série de valeur logique constante suivant la revendication 8, comprenant en outre l'étape d'utilisation de ladite entrée de valeur logique afin de faciliter la commande d'une entrée d'une porte logique (581) au cours d'opérations de test.
